# EUROPEAN PATENT APPLICATION

(11) **EP 4 254 482 A1**
(43) Date of publication of application: **04.10.2023**
(21) Application number: 21896661.2
(22) Date of filing: 22.10.2021
(51) Int. Cl.: H01L 23/04, H01L 21/52, H05K 1/18

(54) **POWER SUB-MODULE AND MANUFACTURING METHOD THEREFOR, AND TRANSFER-MOLDED CRIMPING-TYPE POWER MODULE**

(30) Priority: 27.11.2020 CN 202011355642
(71) Applicant: Zhuzhou CRRC Times Semiconductor Co., Ltd., Zhuzhou, Hunan 412005 (CN)
(72) Inventor: LI, Han, Zhuzhou, Hunan 412005 (CN); LUO, Haihui, Zhuzhou, Hunan 412005 (CN); LI, Xingfeng, Zhuzhou, Hunan 412005 (CN); SHI, Tingchang, Zhuzhou, Hunan 412005 (CN); CHANG, Guiqin, Zhuzhou, Hunan 412005 (CN); PENG, Yongdian, Zhuzhou, Hunan 412005 (CN); ZENG, Xiong, Zhuzhou, Hunan 412005 (CN); ZHANG, Wenhao, Zhuzhou, Hunan 412005 (CN)
(74) Representative: Petraz, Gilberto Luigi
(86) International application number: PCT/CN2021/125472
(87) International publication number: WO 2022/111159

(57) **Abstract**

The present invention relates to a power sub-module and a manufacturing method therefor, and a transfer-molded crimping-type power module, which relate to the technical field of power electronics, and are used for solving the technical problems of a structure being complicated, and the packaging reliability being poor. The power sub-unit in the present invention comprises an insulating rubber frame and a chip. Since the insulating rubber frame is formed of rubber which is directly subjected to mold transfer on a chip assembly, a plurality of procedures in the prior art of placing components, such as a single chip, an upper molybdenum sheet and a lower molybdenum sheet, into a side frame one by one and then positioning same one by one are saved on. Therefore, the positioning procedure is simplified. Moreover, since the insulating rubber frame is integrally formed, there is an assembly gap, and a subsequent coating treatment is not necessary, thus also simplifying the coating procedure. Therefore, the procedures for the power sub-unit in the present invention are simple and are easily operated; furthermore, the power sub-unit is enabled to achieve a protection mode of integrated insulation of the power sub-unit, thereby ensuring the good insulation effect and packaging reliability.

## Description

### Cross-reference of related applications

The present application claims the priority of Chinese Patent Application No. 202011355642.5 entitled "Power submodule and manufacturing method therefor, and transfer-molded crimping-type power module" and filed on November 27, 2020, the content of which is incorporated herein by reference in its entirety.

### Field of the present invention

The present disclosure relates to the technical field of power electronics, in particular to a power submodule and manufacturing method therefor, and a transfer-molded crimping-type power module.

### Background of the present invention

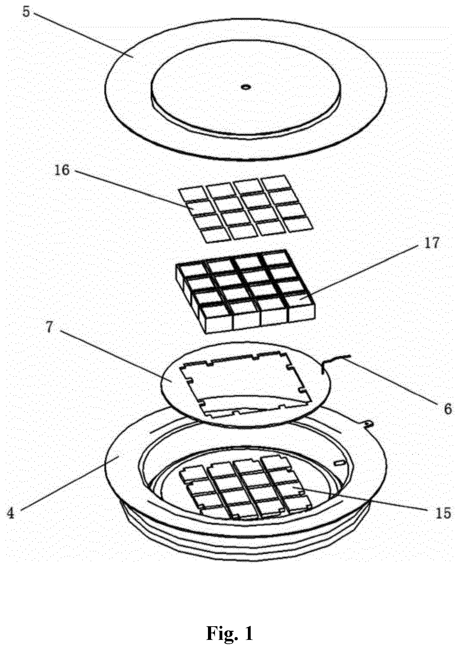

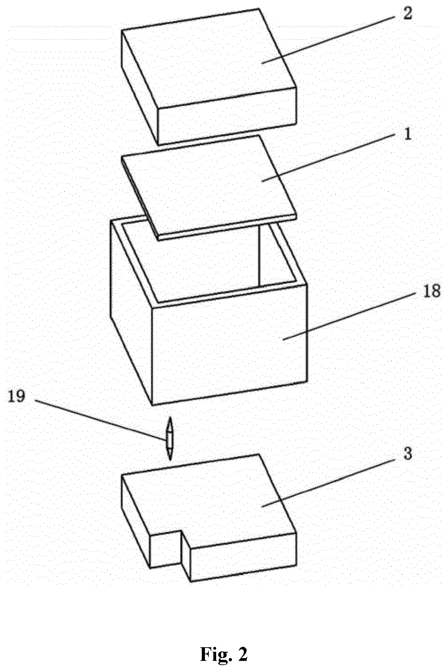

Chinese Patent CN105679750B discloses a crimping-type semiconductor module and manufacturing method therefor, in which a structure of packaging of the semiconductor module is as shown in Figs. 1 and 2, and comprises: semiconductor chips 1, upper molybdenum sheets 2, lower molybdenum sheets 3, a tube base 4, a tube cover 5, a gate leading-out terminal 6 and a PCB 7. An upper molybdenum sheet 2 is arranged on the upper surface of a semiconductor chip 1, a lower molybdenum sheet 3 is arranged on the lower surface of the semiconductor chip 1, and the lower molybdenum sheet 3 has a structure of large molybdenum disc. The semiconductor chip 1 comprises an IGBT chip or an MOSFET chip. The collector/drain of the IGBT chip/MOSFET chip is sintered onto the lower molybdenum sheet 3, and is used as the collector/drain of the crimping-type semiconductor module; the upper molybdenum sheet 2 is sintered with the emitter/source of the IGBT chip/MOSFET chip, and is used as the emitter/source of the crimping-type semiconductor module; the PCB 7 is arranged on the lower molybdenum sheet 3 sintered with the semiconductor chip 1, and the gate of the IGBT chip/MOSFET chip is interconnected to the PCB 7 by wire bonding and is collected to the gate leading-out terminal 6 through an internal circuit of the PCB 7. The semiconductor chip 1 respectively sintered with the upper molybdenum sheet 2 and the lower molybdenum sheet 3 is fixed onto a boss 15 of the tube base 4 by the PCB 7, and the lower molybdenum sheet 3 sintered with the semiconductor chip 1 is fixed onto the tube base 4. The tube cover 5 is arranged above the upper molybdenum sheets 2.

A subunit 17 in the above modular has the following disadvantages: its structure is complex; a number of positions are required to be fixed at the locations between the lower molybdenum sheet 3 and the boss 15 on the tube base 4 and between the upper molybdenum sheet 2 and a side frame 18; the reliability of packaging is poor; the insulation effect is poor; and many complicated procedures are involved.

### Summary of the present invention

The present disclosure provides a power subunit and manufacturing method therefor, and a transfer-molded crimping-type power module in order to solve at least one of the above technical problems.

According to a first aspect of the present disclosure, the present disclosure provides a transfer-molded crimping-type power module, comprising an insulation adhesive frame and a chip assembly;
wherein the insulation adhesive frame is formed by directly transfer molding adhesive on the chip assembly.

In one implementation, the chip assembly comprises a chip, a first molybdenum sheet arranged on a first surface of the chip and a second molybdenum sheet arranged on a second surface of the chip, the first molybdenum sheet is connected with a first electrode of the chip, and the second molybdenum sheet is connected with a second electrode of the chip; and
at least partial side walls of the second molybdenum sheet and/or at least partial side walls of the first molybdenum sheet is wrapped by the insulation adhesive frame.

In one implementation, an upper surface of the second molybdenum sheet and inner walls of the insulation adhesive frame enclose a recess.

In one implementation, the chip assembly further comprises a spring needle, the first surface of the chip is further provided with a third electrode, a third electrode pad is arranged on the third electrode, a third electrode bottom pillar is arranged on the third electrode pad, the third electrode bottom pillar is in snap-fit connection with one end of the spring needle, and the other end of the spring needle is arranged to be outside the insulation adhesive frame.

In one implementation, the spring needle is made of beryllium copper.

According to a second aspect of the present disclosure, the present disclosure provides a manufacturing method for a power module subunit, comprising steps of:
S110, connecting a first surface and a second surface of a chip with a first molybdenum sheet and a second molybdenum sheet, respectively, by welding or sintering, and allowing the first molybdenum sheet to lead out a first electrode of the chip, and the second molybdenum sheet to lead out a second electrode of the chip;
Step S120, welding a third electrode bottom pillar on a third electrode pad of the chip, and connecting one end of a spring needle to the third electrode bottom pillar in a snap-fit manner, so as to obtain a chip assembly; and
Step S130, placing the chip assembly in a transfer molding apparatus, in which an insulation adhesive frame is formed by directly transfer molding adhesive on the chip assembly, so as to obtain the power module subunit.

In one implementation, bubbles inside insulation protection adhesive are extracted by vacuuming before the insulation protection adhesive is cured.

According to a third aspect of the present disclosure, the present disclosure provides a transfer-molded crimping-type power module, comprising:
at least one power subunit as described above;
a circuit board unit, in contact with a third electrode of the power subunit; and
a tube cover unit, arranged on one side of the circuit board unit away from the power subunit;
wherein the tube cover unit comprises a tube cover and a crimping assembly which are detachable from each other, the crimping assembly comprises projections toward the circuit board unit, and the projections are configured to allow the circuit board unit in pressure-bearing contact with the third electrode of the power subunit.

In one implementation, the circuit board unit is provided thereon with bonding pads, each of which is configured to connect to a third electrode; and
the number of the bonding pads, the number of the projections and the number of power subunits are equal and correspond to one another.

In one implementation, the transfer-molded crimping-type power module further comprises a tube base unit which comprises a tube base and an insulation positioning frame arranged in the tube base, the power subunit is arranged in the insulation positioning frame, and the tube base is further provided thereon with a conductive terminal which is configured to lead out a signal of the third electrode.

In one implementation, the crimping assembly further comprises a buffer layer, the projections are arranged on one side of the buffer layer close to the circuit board unit, and the buffer layer is provided thereon with an accommodation section which is configured to accommodate the conductive terminal.

In one implementation, a first brim in a circumferential direction of the tube base is in sealed connection with a second brim in a circumferential direction of the tube cover.

In one implementation, the tube base is made of a first metal; a surface of the tube base is plated with a second metal layer, the first metal being identical with or different from the second metal; and the projections are made of the first metal.

Compared with the existing technology, the advantages of the present disclosure lie in that,
(1) Since the insulation adhesive frame is formed by directly transfer molding adhesive on the chip assembly, a plurality of procedures in the existing technology including placing components, such as a single chip, an upper molybdenum sheet, a lower molybdenum sheet, etc., into a side frame one by one and then positioning them one by one can be omitted. Accordingly, the procedure of positioning is simplified. Moreover, since the insulation adhesive frame is integrally formed as one-piece, there is no assembly clearance, and a subsequent adhesive coating treatment is not necessary, thereby omitting the procedure of adhesive coating. As a result, the operation procedures for the power subunit in the present disclosure are simple and easy to be operated. Furthermore, a protection mode of one-step integrated insulation of the power subunits 300 can be achieved, thereby ensuring good insulation effect and packaging reliability.
(2) In the power subunit of the present disclosure, the chip assembly is wrapped by the insulation adhesive frame. Since the insulation adhesive frame is integrally formed as one-piece, there is no assembly clearance. Preferably, the insulation adhesive frame completely wraps the side walls of the second molybdenum sheet and at least wraps partial side walls of the first molybdenum sheet, thereby increasing a creepage distance between the surface of the second molybdenum sheet and the surface of the first molybdenum sheet so as to allow the power subunit per se to achieve a higher insulation protection capacity.
(3) The spring needle is connected with the gate of the chip through the third electrode bottom pillar. Accordingly, while the insulation adhesive frame is forming by transfer molding, the spring needle has been fixedly connected with the third electrode bottom pillar, which can facilitate the transfer molding of the insulation adhesive frame and can improve the reliability and processability of interconnection as well as the reliability of electromagnetic connection
(4) Since the insulation adhesive frame is formed by the transfer molding method, a procedure for fixing of a number of positions between the chip, the molybdenum sheet and the side frame, which is required to be separately performed in the existing technology, are avoided, and the manufacturing process of the power subunit can be simplified into three steps, thereby simplifying process, improving manufacturing efficiency, and reducing production cost.
(5) Since the tube cover unit is configured to comprise a tube cover and a crimping assembly which are detachable from each other, the difficulty of machining the projections on the crimping assembly is lessened such that the surface accuracy of the projection can be improved, thereby ensuring the reliability of pressure transmission and improving the manufacturability of the transfer-molded crimping-type power module.
(6) Since the crimping assembly further comprises the buffer layer, it is possible to facilitate release of residual stress, thereby alleviating the deformation of the tube cover and the power subunit.

### Brief Description of the Drawings

Hereinafter, the present disclosure will be described in more detail based on the embodiments with reference to the accompanying drawings.
Fig. 1 is an exploded view of a structure of packaging of a crimping-type module in the prior art;
Fig. 2 is an exploded view of a subunit of Fig. 1;
Fig. 3 is an exploded view of a power subunit according to an embodiment of the present disclosure;
Fig. 4 is a sectional view of a power subunit according to an embodiment of the present disclosure;
Fig. 5 is a schematic diagram of circuit topology of a power subunit according to an embodiment of the present disclosure;
Figs. 6-8 are schematic diagrams of a manufacturing process of a power subunit according to an embodiment of the present disclosure;
Fig. 9 is an exploded view of a transfer-molded crimping-type power module according to an embodiment of the present disclosure;
Fig. 10 is a schematic diagram of a stereostructure of a crimping-type assembly as shown in Fig. 9;
Fig. 11 is a schematic diagram of a stereostructure of a circuit board unit as shown in Fig. 9; and
Fig. 12 is a sectional view of a transfer-molded crimping-type power module according to an embodiment of the present disclosure.

### Reference Numerals:

100-tube cover unit; 110-cover; 111-second brim; 120-crimping assembly; 121-buffer layer; 122-projection; 123-U-shaped notch.

### Detailed Description of the Embodiments

Hereafter, the present disclosure will be further described in conjunction with the accompanying drawings.

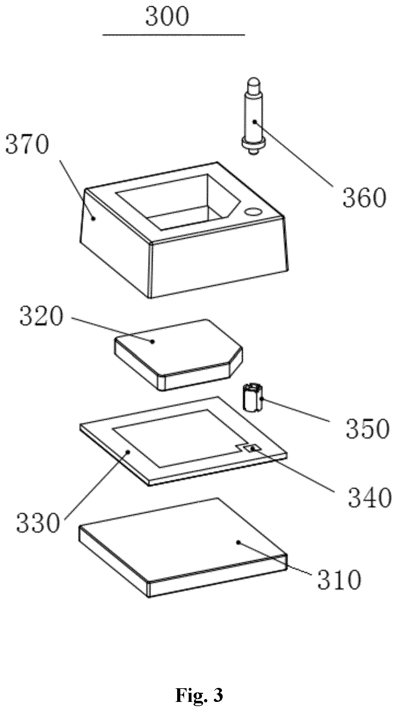

As shown in Figs. 3-5, according to a first aspect of the present disclosure, the present disclosure provides a power subunit 300, comprising an insulation adhesive frame 370 and a chip assembly. Different from the existing technology, the insulation adhesive frame 370 of the present disclosure is formed by directly transfer molding an adhesive body (preferably, insulation protection adhesive) on the chip assembly, such that a plurality of procedures in the existing technology including placing components, such as a single chip, an upper molybdenum sheet, and a lower molybdenum sheet, etc., into a side frame one by one and then positioning them one by one can be omitted. Accordingly, not only a production process is simplified, but also a protection mode of one-step integrated insulation of the power subunits 300 can be achieved, thereby ensuring good insulation effect and packaging reliability.

In addition, since the insulation protection adhesive is transparent, defects such as bubbles, etc. inside the adhesive can be observed so that the bubbles inside the adhesive can be extracted by vacuuming, etc. before the adhesive is cured, thereby improving process manufacturability.

Hereafter, the present disclosure will be illustrated in detail by taking a case in which the power subunit 300 is an IGBT subunit as an example.

As shown in Figs. 3-5, the chip assembly comprises a chip 330, and a first molybdenum sheet (lower molybdenum sheet) 310 and a second molybdenum sheet (upper molybdenum sheet) 320 arranged on a first surface (the bottom) and a second surface (the top) of the chip 330, respectively. The first molybdenum sheet 310 is connected to a first electrode (the collector) of the chip 330, and the second molybdenum sheet 320 is connected with a second electrode (emitter) of the chip 330, that is, the first molybdenum sheet 310 leads out the collector of the IGBT subunit, and the second molybdenum sheet leads out the emitter of the IGBT subunit.

Since the insulation adhesive frame 370 is formed by performing direct transfer molding on the chip assembly, the molded insulation adhesive frame 370 can be integrally formed with a first molybdenum sheet accommodation section (which may be, for example, a groove and/or a boss) for matching with the first molybdenum sheet 310 and a second molybdenum sheet accommodation section (which may be, for example, a groove and/or boss) for matching with the second molybdenum sheet 320, such that at least partial side walls of the second molybdenum sheet 320/or at least partial side walls of the first molybdenum sheet 310 are wrapped by an insulation adhesive frame 370, thereby ensuring the insulation performance thereof.

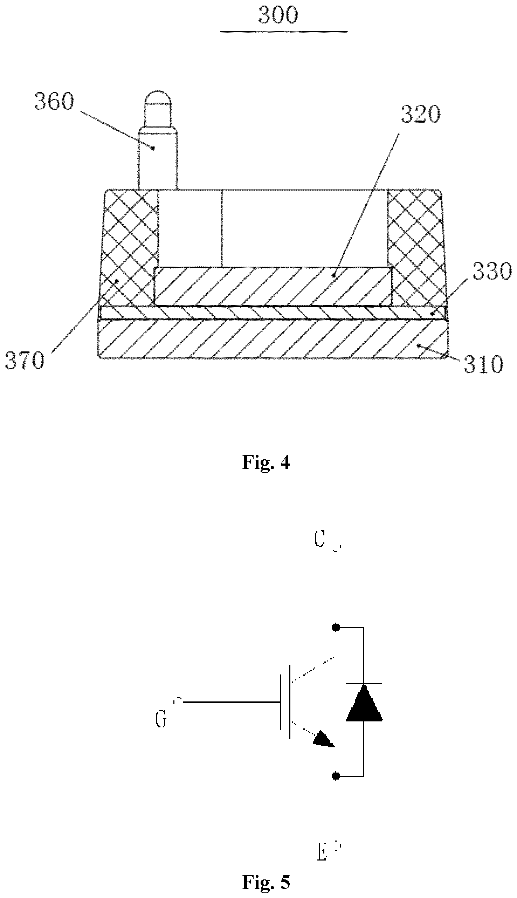

In a preferred embodiment as shown in Fig. 4, the insulation adhesive frame 370 completely warps the side walls of the second molybdenum sheet 320 and at least warps partial side walls of the first molybdenum sheet 310, the purpose of which is to increase a creepage distance between the surface of the second molybdenum sheet 320 and the surface of the first molybdenum sheet 310 so as to allow the IGBT subunit to achieve a higher insulation protection capacity.

As described above, the insulation adhesive frame 370 is formed by transfer molding. Accordingly, the insulation adhesive frame 370 can be integrally formed with a chip accommodation section, the first molybdenum sheet accommodation section and the second molybdenum sheet accommodation section such that the insulation adhesive frame 370 per se has positioning function and can also improve insulation effect.

Further, the upper surface of the second molybdenum sheet 320 and the inner walls of the insulation adhesive frame 370 enclose a recess that can accommodate a projection 122. The recess will form a clearance fit with the projection 122 described below.

The chip assembly further comprises a spring needle 360. The top surface of the chip 330 is also provided with a third electrode (the gate). A third electrode pad 340 is arranged on the third electrode, and a third electrode bottom pillar 350 is arranged on the third electrode pad 340. The third electrode bottom pillar 350 is in snap-fit connection with one end of the spring needle 360, and the other end of the spring needle 360 is arranged to be outside the insulation adhesive frame 370 such that the other end of the spring needle 360 is higher than the top surface of the insulation adhesive frame 370.

As a difference from the existing technology, the spring needle 360 of the present disclosure is connected to the gate of the chip 330 through the third electrode bottom pillar 350. Accordingly, while the insulation adhesive frame is forming by transfer molding, the spring needle has been fixedly connected with the third electrode bottom pillar, which can facilitate transfer molding of the insulation adhesive frame and can improve the reliability and processability of interconnection as well as the reliability of electromagnetic connection.

In addition, in the existing technology, a spring needle can be put into the side frame only after the chip, the upper molybdenum sheet and the lower molybdenum sheet are positioned in and connected to the side frame, respectively. In other words, before a pressure is applied, there is no effective and reliable connection formed between the spring needle and the chip. As a result, after a pressure is applied, there may be a phenomenon that no contact is formed due to improper press-fitting. In the present disclosure, a fixed connection has been formed between the spring needle and the chip 330 through the third electrode bottom pillar 350 before the insulation adhesive frame is formed such that the connection reliability can be improved.

In addition, the spring needle 360, as a gate leading-out interface of the IGBT subunit, may be made of beryllium copper.

As shown in Fig. 4, since the other end of the spring needle 360 is higher than the top surface of the insulation adhesive frame 370, it can be ensured that a bonding pad on the lower surface of a circuit board unit 200 described below can be effectively in pressure-bearing contact with the spring needle 360.

As shown in Fig. 5, a structure of circuit topology of the IGBT subunit is shown, in which C is the collector of an IGBT, E is the emitter of the IGBT, and G is the gate of the IGBT. The IGBT subunit realizes power switch function and electric energy conversion function through gate drive signals.

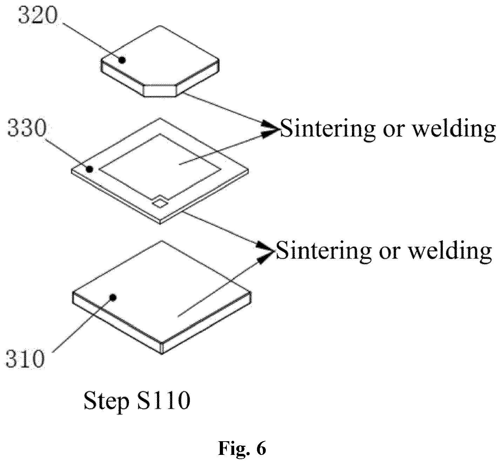

As shown in Figs. 6-8, according to a second aspect of the present disclosure, the present disclosure provides a method for preparing the above power subunit, comprising the following steps S110 to S 130.

At step S 110, as shown in Fig. 6, a first surface (bottom surface) and a second surface (top surface) of a chip 330 are connected to a first molybdenum sheet 310 and a second molybdenum sheet 320, respectively, by welding or sintering, and the first molybdenum sheet 310 is allowed to lead out a first electrode (the collector) of the chip 330, and the second molybdenum sheet 320 is allowed to lead out a second electrode (the emitter) of the chip 330.

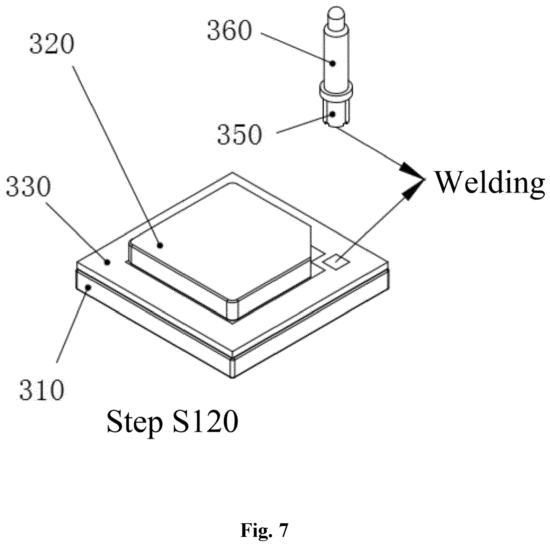

At step S120, as shown in Fig. 7, a third electrode bottom pillar 350 is welded on a third electrode pad 340 on the top surface of the chip 330, and one end (lower end) of a spring needle 360 is inserted into the third electrode bottom pillar 350 such that the two are in snap-in (or insert-in) connection. Therefore, a chip assembly is obtained thereby. In this case, the third electrode bottom pillar 350 serves as a third electrode (gate) leading-out interface of the chip 330.

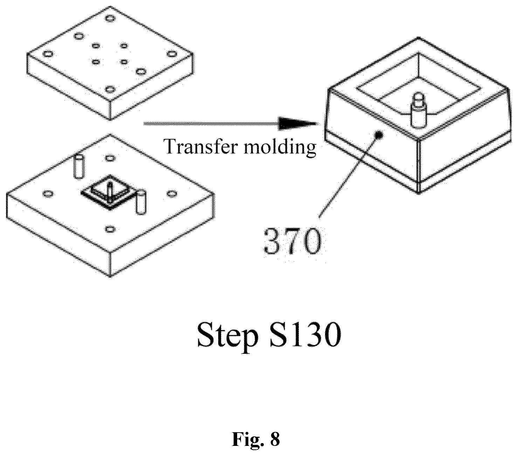

At step S130, as shown in Fig. 8, the chip assembly is placed in a transfer molding apparatus, in which an insulation adhesive frame 370 is formed by directly transfer molding adhesive on the chip assembly. Therefore, a power module subunit 300 is obtained thereby.

In this case, the bubbles inside insulation protection adhesive are extracted by vacuuming, etc. before the insulation protection adhesive is cured.

Further, since the insulation adhesive frame is formed by the transfer molding method, a procedure for fixing of a number of positions which is required to be performed separately in the existing technology can be avoided, and thus the manufacturing process of the power subunit can be simplified into three steps, thereby simplifying the operation process, improving manufacturing efficiency, and reducing production cost.

In Fig. 8, shown on the left side of the insulation adhesive frame 370 is a mold unit of the transfer molding apparatus.

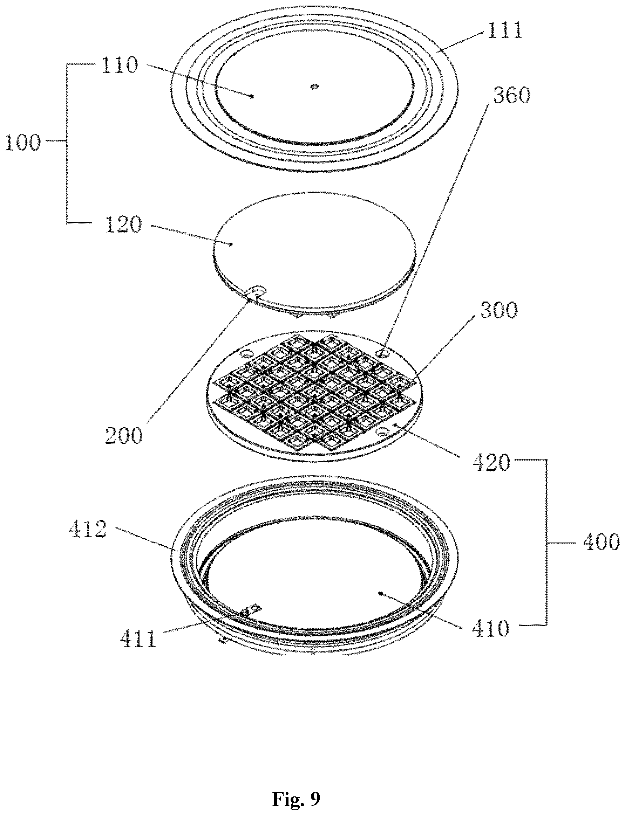

As shown in Figs. 9-12, according to a third aspect of the present disclosure, the present disclosure provides a transfer-molded crimping-type power module, comprising a tube cover unit 100, a circuit board unit (PCB control board) 200, and at least one power subunits 300 described above. In some embodiments, a tube base unit 400 may be further included.

In a specific embodiment, a plurality of power subunits 300 are provided, and the plurality of power subunits 300 are arranged substantially in the form of a rectangular shape. It should be understood that the plurality of power subunits 300 may also be arranged in other forms, such as round shape, oval shape, etc., which may not be limited thereto in the present disclosure.

Specifically, the circuit board unit 200 is in contact with the third electrodes of the power subunits 300. The tube cover unit 100 is arranged on one side of the circuit board unit 200 away from the power subunits 300. The tube cover unit 100 comprises a tube cover 110 and a crimping assembly 120 which are detachable from each other. The crimping assembly 120 comprises projections 122 projecting toward the circuit board unit 200, and the projections 122 are configured to make the circuit board unit 200 in pressure-bearing contact with the third electrodes of the power subunits 300.

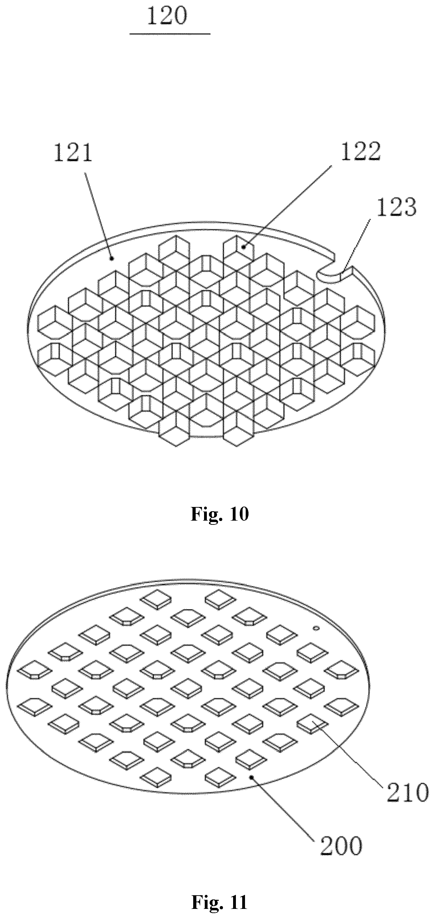

In some embodiments, the projections 122 are made of metal material. More specifically, the projections 122 are made of copper. As shown in Fig. 10, the projections 122 are columnar bosses, and thus may also be called copper bosses.

Since the tube cover unit 100 is configured to comprise the tube cover 110 and the crimping assembly 120 which are detachable from each other, the difficulty of machining the projections 122 (copper bosses) on the crimping assembly 120 is reduced. Thus, a surface accuracy of the projections 122 can be improved so as to ensure the reliability of pressure transmission.

The circuit board unit 200 is provided thereon with bonding pads which are configured to connect with the third electrodes of the power subunits 300. In this case, the number of the bonding pads, the number of the projections 122 and the number of the power subunits 300 are the same and match with one another, which makes the circuit board unit 200, the power subunits 300 and the tube cover unit 100 easy to assemble together, thereby improving manufacturability.

The circuit board unit 200 is arranged on the lower surface of the crimping assembly 120. It should be understood that, the circuit board unit 200 may be provided thereon with grooves 210 through which the projections 122 pass, as shown in Fig. 11. The projections 122 enables the circuit board unit 200 to be in pressure-bearing contact connection with the third electrodes of the power subunits 300.

After the projections 122 pass through the grooves 210 of the circuit board unit 200, the circuit board unit 200 may be in contact with the lower surface of a buffer layer 121. Since the other end of the spring needle 360 is higher than the top surface of the insulation adhesive frame 370, an effective pressure-bearing contact connection may be formed between a bonding pad on the lower surface of the circuit board unit 200 and a spring needle 360 of a power subunit 300 related to the bonding pad when a pressure is applied to the circuit board unit 200 through the crimping unit 200.

Specifically, after passing through the grooves 210 of the circuit board unit 200, the projections 122 extend into the recesses of the insulation adhesive frames 370, and forms a clearance fit. As described above, when a pressure is applied to the circuit board unit 200 through the crimping unit 200, each projection is inserted into a insulation adhesive frame 370 of a IGBT subunit related to the projection, and forms a clearance fit with the related insulation adhesive frame 370, thus improving the accuracy of positioning thereof.

Since the third electrodes are the gates of the IGBT subunits, the bonding pads of the circuit board unit 200 and the gates of the IGBT subunits realize electrical contact through the pressure-bearing contact connection, and finally the gates of respective IGBT subunits are collected as a whole.

The crimping assembly 120 further comprises the buffer layer 121, and the projections 122 are arranged on the side of the buffer layer 121 close to the circuit board unit 200. The buffer layer 121 can facilitate release of residual stress, thereby lessening deformation of the tube cover 110 and the power subunits 300.

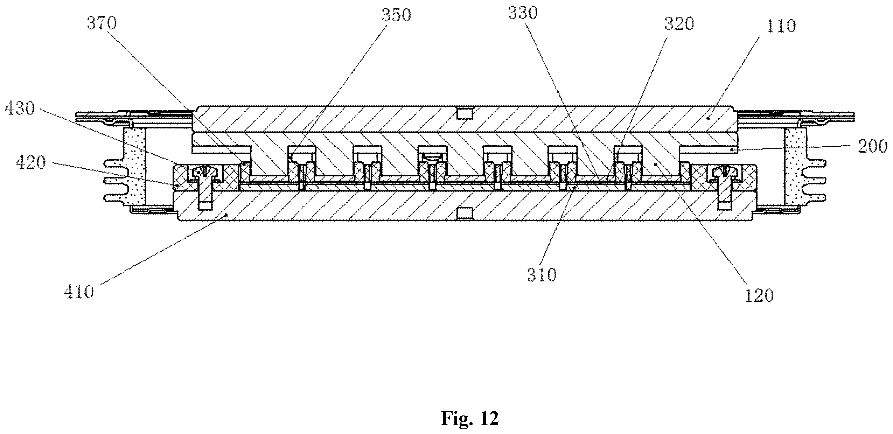

As shown in Fig. 9, the tube base unit 400 comprises a tube base 410 and an insulation positioning frame 420 arranged in the tube base 410. As shown in Fig. 12, the insulation positioning frame 420 is fixedly connected to the tube base 410 through fasteners 430. The insulation positioning frame 420 may generally be made of materials with good insulation performance, such as epoxy resin, etc.

The insulation positioning frame 420 is provided with openings which are corresponding to the power subunits 300 in a one-to-one manner, and the respective power subunits 300 are arranged inside the openings of the insulation positioning frame 420, respectively, such that the individual power subunits 300 are accurately and reliably positioned in the tube base 410.

The tube base 410 is also provided thereon with a conductive terminal 411 which is configured to lead out signals of the third electrodes (the gates) of the power subunits 300. In an embodiment as shown in Fig. 9, the conductive terminal 411 has a thin sheet-like structure, one end of which is connected to the inner wall of the tube base 410, and the other end of which extends along a radial direction of the tube base 410 after being bended. Therefore, the conductive terminal 411 may be called a gate leading-out lug.

As shown in Fig. 10, the buffer layer 121 is provided thereon with an accommodation section 123 which is configured to accommodate the conductive terminal 411. The position of the conductive terminal 411 and the position of the accommodation section 123 are fit to each other. When the tube cover unit 100 and the circuit board unit 200 are pressed onto the power subunits 300, the conductive terminal 411 is exactly arranged inside the accommodation section 123. The accommodation section 123 can make the conductive terminal 411 contact with the circuit board unit 200 such that the gate signals of the respective power subunits 300 collected by the circuit board unit 200 can be led out, thereby enabling connection with an external driver and a control circuit.

In this case, the accommodation section may have a structural form of an opening, a hole, a notch, etc. In an embodiment as shown in Fig. 10, the accommodation section is a U-shaped notch.

The tube base 410 may be made of a first metal (such as copper), and has a relatively smooth surface to improve surface accuracy, thereby ensuring reliable transmission of the contact pressure. The surface of the tube base 410 may be provided with a layer of a second metal, which, for example, may be a silver plated layer, so as to improve the thermal conductivity thereof. In addition, the first metal may be the same with or different from the second metal.

As shown in Fig. 9, a first brim 412 in the circumferential direction of the tube base 410 is in sealed connection with a second brim 111 in the circumferential direction of the tube cover 110. Specifically, the tube base 410 may be in sealed connection with the tube cover 110 by cold-pressing welding process to improve the reliability of packaging, thereby protecting the power subunits 300 therein and achieving an explosion-proof effect.

After the tube base 410 is in sealed connection with the tube cover 110, the first molybdenum sheet 310 of each power subunit 300 is in direct pressure contact with the tube base 410, the second molybdenum sheet 330 of each power subunit 300 is in direct pressure contact with a projection 122, and the projection 122 is in direct pressure contact with the tube cover 110, such that a main circuit of a IGBT subunit is formed thereby. The upper surface of the tube cover 110 is the emitter of the IGBT subunit, and the lower surface of the tube cover 110 is the collector of the IGBT subunit.

Therefore, in the transfer-molded crimping-type power module of the present disclosure, it is possible to package, according to a desired level of current, a certain number of the power subunits (IGBT subunits) 300 in parallel to form a power module (IGBT module), wherein each power subunit 300 has independent electrical characteristics. In this case, the power subunits have a flexible layout, and they may be distributed in a circular shape, a rectangular shape, etc; accordingly, the tube base 410 and the tube cover 110 may also be a circular or rectangular shape. The embodiment as shown in Fig. 9 shows an IGBT module, in which packaging with a tubular shell is adopted and the IGBT subunits are in a substantially rectangular layout.

The IGBT described above is an insulated gate bipolar transistor, which is a semiconductor power switch device. The IGBT subunit is a unit of subassembly of the in-parallel crimping-type IGBT module, and has independent electrical characteristics. The crimping-type IGBT module exhibits a pattern of packaging of IGBT module, namely, a crimping-type packaging, which has the characteristics of lead wire-free bonding, double-sided heat dissipation and short circuit triggered upon failure, and thus it has lower thermal resistance, higher operating junction temperature, lower parasitic inductance, wider safe working area and higher reliability. The crimping-type IGBT module is mainly applied in the field of flexible DC electric transmission, and also has competitive advantages in the occasions with constrained application environment and higher reliability requirements.

The pressure-bearing contact described above can be implemented in two manners, one of which is direct pressure contact, and the other of which is spring contact.

Although the present disclosure has been described with reference to preferred embodiments, various improvements to the embodiments may be made and the components therein may be replaced with equivalents without departing from the scope of the present disclosure. In particular, as long as there is no structural conflict, the technical features mentioned in respective embodiments may be combined in any form. The present disclosure is not limited to the specific embodiments disclosed herein, but encompasses all of the technical solutions falling within the scope of the attached claims.

## Claims

1. A power module subunit, comprising an insulation adhesive frame and a chip assembly;
wherein the insulation adhesive frame is formed of adhesive which is directly subjected to transfer molding on the chip assembly.

2. The power module subunit according to claim 1, **characterized in that**, the chip assembly comprises a chip, a first molybdenum sheet arranged on a first surface of the chip and a second molybdenum sheet arranged on a second surface of the chip, the first molybdenum sheet is connected with a first electrode of the chip, and the second molybdenum sheet is connected with a second electrode of the chip; and
at least partial side walls of the second molybdenum sheet and/or at least partial side walls of the first molybdenum sheet is wrapped by the insulation adhesive frame.

3. The power module subunit according to claim 2, **characterized in that**, an upper surface of the second molybdenum sheet and inner walls of the insulation adhesive frame enclose a recess.

4. The power module subunit according to any one of claims 1-3, **characterized in that**, the chip assembly further comprises a spring needle, the first surface of the chip is further provided with a third electrode, a third electrode pad is arranged on the third electrode, a third electrode bottom pillar is arranged on the third electrode pad, the third electrode bottom pillar is in snap-fit connection with one end of the spring needle, and another end of the spring needle is arranged to be outside the insulation adhesive frame;
wherein the spring needle is made of beryllium copper.

5. A manufacturing method for a power module subunit, comprising steps of:
S110, connecting a first surface and a second surface of a chip with a first molybdenum sheet and a second molybdenum sheet, respectively, by welding or sintering, and allowing the first molybdenum sheet to lead out a first electrode of the chip, and the second molybdenum sheet to lead out a second electrode of the chip;
Step S120, welding a third electrode bottom pillar on a third electrode pad of the chip, to connecting one end of a spring needle to the third electrode bottom pillar in a snap-fit manner, so as to obtain a chip assembly; and
Step S130, placing the chip assembly in a transfer molding apparatus, in which an insulation adhesive frame is formed by directly transfer molding adhesive on the chip assembly, so as to obtain the power module subunit,
wherein at the step S130, bubbles inside insulation protection adhesive are extracted by vacuuming before the insulation protection adhesive is cured.

6. A transfer-molded crimping-type power module, comprising:
at least one power module subunit according to any one of claims 1-4;
a circuit board unit, in contact with a third electrode of the power module subunit; and
a tube cover unit, arranged on one side of the circuit board unit away from the power module subunit;
wherein the tube cover unit comprises a tube cover and a crimping assembly which are detachable from each other, the crimping assembly comprises projections toward the circuit board unit, and the projections are configured to allow the circuit board unit in pressure-bearing contact with the third electrode of the power module subunit.

7. The transfer-molded crimping-type power module according to claim 6, **characterized in that**, the circuit board unit is provided thereon with bonding pads, each of which is configured to connect with a third electrode;
wherein the number of the bonding pads, the number of the projections and the number of power module subunits are equal and correspond to one another.

8. The transfer-molded crimping-type power module according to claim 8 or 9, further comprising a tube base unit which comprises a tube base and an insulation positioning frame arranged in the tube base, the power module subunit is arranged in the insulation positioning frame, and the tube base is further provided thereon with a conductive terminal which is configured to lead out a signal of the third electrode; and
a first brim in a circumferential direction of the tube base is in sealed connection with a second brim in a circumferential direction of the tube cover.

9. The transfer-molded crimping-type power module according to claim 8, **characterized in that**, the crimping assembly further comprises a buffer layer, the projections are arranged on one side of the buffer layer close to the circuit board unit, and the buffer layer is provided thereon with an accommodation section which is configured to accommodate the conductive terminal.

10. The transfer-molded crimping-type power module according to claim 8, **characterized in that**, the tube base is made of a first metal; a surface of the tube base is plated with a second metal layer, wherein the first metal is identical with or different from the second metal; and
the projections are made of the first metal.
